# DEMANDE DE BREVET EUROPEEN

(11) **EP 3 913 657 A2**
(43) Date de publication de la demande: **24.11.2021**
(21) Numéro de dépôt: 21172791.2
(22) Date de dépôt: 07.05.2021
(51) Int. Cl.: H01L 21/60, H01L 21/66, H01L 23/485, H01L 21/768

(54) **PROCÉDÉ DE TRAITEMENT D'UN CIRCUIT ÉLECTRONIQUE POUR UN COLLAGE MOLÉCULAIRE HYBRIDE**

(30) Priorité: 19.05.2020 FR 2005055
(71) Demandeur: Commissariat à l'Energie Atomique et aux Energies Alternatives, 75015 Paris (FR)
(72) Inventeur: BOURJOT, Emilie, 38054 GRENOBLE CEDEX 09 (FR); JOUVE, Amandine, 38054 GRENOBLE CEDEX 09 (FR); FOURNEL, Frank, 38054 GRENOBLE CEDEX 09 (FR); DUBARRY, Christophe, 38054 GRENOBLE CEDEX 09 (FR)
(74) Mandataire: Cabinet Beaumont

(57) **Abrégé**

La présente description concerne un procédé de traitement d'un circuit électronique (10) comprenant à un emplacement au moins un plot de test (14) conducteur électriquement ayant une première face (16) exposée. Le procédé comprend la gravure au moins partielle du plot de test par la première face, et la formation sur le circuit électronique d'un niveau d'interconnexion recouvrant ledit emplacement et comprenant, du côté opposé audit emplacement, une deuxième face plane adaptée pour la réalisation d'un collage moléculaire hybride.

## Description

### Domaine technique

La présente description concerne de façon générale un procédé de traitement d'un circuit électronique, notamment la préparation d'un circuit électronique pour la réalisation d'un collage moléculaire hybride.

### Technique antérieure

Un exemple de procédé de fabrication de dispositifs électroniques comprend la formation de deux plaques de circuits intégrés comprenant chacune une face correspondant à la face libre d'une couche isolante au niveau de laquelle affleurent des plots conducteurs de collage (HBM, sigle anglais pour Hybrid Bonding Metal pads), et la fixation l'une à l'autre de ces faces par collage moléculaire hybride, mettant en contact les plots HBM des deux plaques et les couches isolantes des deux plaques. Les plaques peuvent ensuite être découpées pour séparer les dispositifs électroniques. D'autres exemples comprennent la fixation par collage moléculaire de puces séparées de circuits intégrés à une plaque de circuits intégrés ou la fixation par collage moléculaire d'une puce de circuits intégrés à une autre puce de circuits intégrés.

La réalisation d'un collage moléculaire implique un état de surface adapté, la surface devant notamment respecter des critères exigeants de planéité, de rugosité, et de propreté. L'obtention de cet état de surface adapté implique généralement une étape de planarisation mécanochimique des plaques de circuits intégrés, également appelée CMP (sigle anglais pour Chemical-Mechanical Planarization), qui combine généralement gravure chimique et mécanique. Un tel procédé peut requérir que les différents matériaux présents en surface des plaquettes de circuits intégrés soient répartis de façon sensiblement homogène. C'est pourquoi il est généralement utilisé des plots HBM de mêmes dimensions, par exemple de forme carrée ou hexagonale, répartis de façon sensiblement homogène sur la face, certains plots HBM n'étant pas connectés électriquement à d'autres éléments de la plaque de circuits intégrés et ne servant que pour le collage moléculaire hybride.

La préparation d'un circuit électronique pour la réalisation d'un collage moléculaire hybride comprend la réalisation d'un niveau d'interconnexion supplémentaire sur le circuit électrique d'origine, appelé niveau d'interconnexion de collage, comprenant notamment le dépôt d'un empilement de couches isolantes et la formation des plots HBM dans l'empilement de couches isolantes, certains des plots HBM étant connectés à des plots conducteurs du circuit électronique par des vias conducteurs (HBV, sigle anglais pour Hybrid Bonding Vias) formés dans l'empilement de couches isolantes.

Pour certaines applications, il est souhaitable de pouvoir vérifier le bon fonctionnement du circuit électronique d'origine avant la préparation du circuit électronique d'origine au collage moléculaire hybride. Dans ce but, il est connu de prévoir des plots conducteurs exposés en surface du circuit électronique d'origine permettant la réalisation de tests. Ces tests peuvent notamment être réalisés en utilisant des pointes de test qui sont appliquées contre les plots de test.

Toutefois, lors de la mise en oeuvre d'un procédé de préparation du circuit électronique pour la mise en oeuvre d'un collage moléculaire hybride, il peut être observé des connexions indésirables entre les plots de test et des plots HBM.

### Résumé de l'invention

Ainsi, un objet d'un mode de réalisation est de pallier au moins en partie les inconvénients des procédés de préparation de circuits électroniques pour un collage moléculaire hybride décrits précédemment.

Un autre objet d'un mode de réalisation est que le procédé de préparation soit compatible avec les procédés classiques de fabrication de circuits électroniques.

Un mode de réalisation prévoit un procédé de traitement d'un circuit électronique comprenant à un emplacement au moins un plot de test conducteur électriquement ayant une première face exposée, comprenant la gravure au moins partielle du plot de test par ladite première face, et la formation sur le circuit électronique d'un niveau d'interconnexion recouvrant ledit emplacement et comprenant, du côté opposé audit emplacement, une deuxième face plane adaptée pour la réalisation d'un collage moléculaire hybride.

Selon un mode de réalisation, le niveau d'interconnexion comprend des plots de collage conducteurs électriquement exposés sur la deuxième face.

Selon un mode de réalisation, le circuit intégré comprend au moins un plot de contact conducteur électriquement, et l'un des plots de collage est connecté au plot de contact par au moins un via conducteur électriquement.

Selon un mode de réalisation, le circuit électronique comprend, avant la formation du niveau d'interconnexion, une couche isolante recouvrant le plot de contact, recouvrant la périphérie du plot de test et traversée d'un trou exposant la première face.

Selon un mode de réalisation, la gravure au moins partielle du plot de test est réalisée au travers du trou en utilisant la couche isolante comme masque de gravure.

Selon un mode de réalisation, le procédé comprend la formation d'un masque de gravure recouvrant le circuit électronique et comprenant une ouverture exposant en totalité ou en partie la première face et la gravure du plot de test au travers de ladite ouverture.

Selon un mode de réalisation, le masque de gravure est au contact de la première face avant l'étape de gravure au moins partielle du plot de test.

Selon un mode de réalisation, l'étape de formation du niveau d'interconnexion comprend une étape de planarisation mécano-chimique.

Selon un mode de réalisation, le procédé comprend, avant l'étape de gravure au moins partielle du plot de test, une étape de test du circuit électronique comprenant l'application d'au moins une pointe conductrice électriquement contre le plot de test.

Selon un mode de réalisation, le procédé comprend le collage moléculaire hybride de la deuxième face à une troisième face d'un autre circuit électronique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un plot de test d'un circuit électronique après une opération de test ;
la figure 2 est une image d'un plot de test après une opération de test ;
la figure 3 est une courbe de profil du plot de test de la figure 2 ;
la figure 4A illustre une étape d'un mode de réalisation d'un procédé de préparation d'un circuit électronique pour un collage moléculaire hybride ;
la figure 4B illustre une autre étape du procédé de préparation ;
la figure 4C illustre une autre étape du procédé de préparation ;
la figure 4D illustre une autre étape du procédé de préparation ;
la figure 4E illustre une autre étape du procédé de préparation ;
la figure 4F illustre une autre étape du procédé de préparation ;
la figure 4G illustre une autre étape du procédé de préparation ;
la figure 4H illustre une autre étape du procédé de préparation ;
la figure 5A illustre une étape d'un autre mode de réalisation d'un procédé de préparation d'un circuit électronique pour un collage moléculaire hybride ; et
la figure 5B illustre une autre étape du procédé de préparation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un circuit électronique dans une position normale d'utilisation. Sauf précision contraire, les expressions "environ", "approximativement", "sensiblement", et "de l'ordre de" signifient à 10 % près, de préférence à 5 % près. Dans la suite de la description, le terme "conducteur" signifie conducteur électriquement et le terme "isolant" signifie isolant électriquement.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Les inventeurs ont mis en évidence que les connexions indésirables de plots HBM lors de la préparation d'un circuit électronique à un collage moléculaire hybride résultent de défauts de surface au niveau de plots de test du circuit électronique qui peuvent empêcher le bon déroulement des procédés connus de préparation du circuit électronique pour un collage moléculaire hybride.

En effet, avant la formation du niveau d'interconnexion de collage, tous les plots conducteurs du dernier niveau de métallisation du circuit électronique sont généralement complètement recouverts d'une couche isolante à l'exception des plots de test qui sont utilisés pour la réalisation de tests avant la préparation du circuit électronique à un collage moléculaire hybride. La couche isolante recouvrant les plots conducteurs du dernier niveau de métallisation est donc ouverte pour exposer une partie de la surface des plots de test. Ces ouvertures peuvent entraîner la formation de marches abruptes. En outre, l'application de pointes de test sur le plot de test peut entrainer la déformation de la surface du plot de test et notamment la formation d'aspérités en surface du plot de test qui rend incompatible le collage moléculaire.

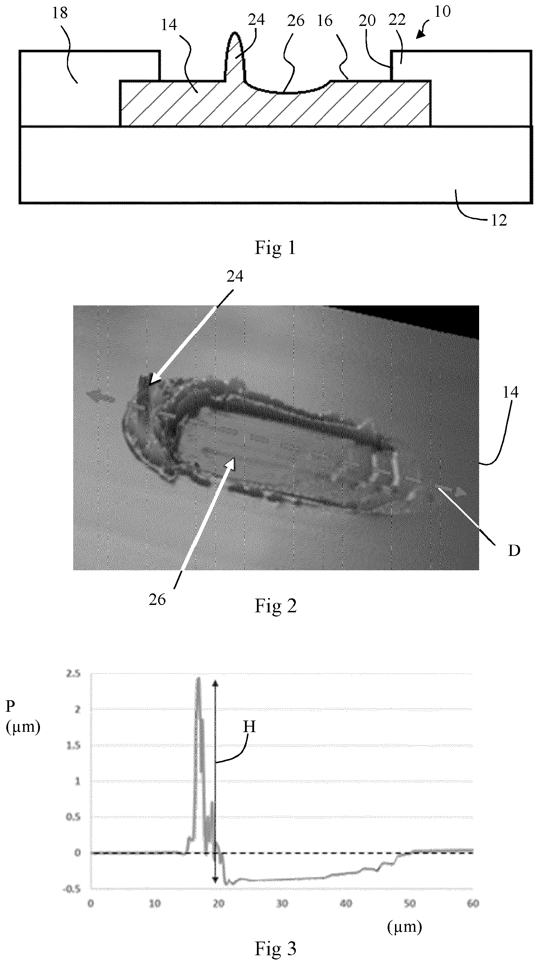

La figure 1 est une vue en coupe, partielle et schématique, d'un circuit électronique 10 comprenant une base 12, contenant le substrat du circuit électronique, des composants électroniques, notamment des transistors, et les niveaux de métallisation inférieurs du circuit électronique 10. Le circuit électronique 10 comprend en outre au moins un plot conducteur 14, appelé plot de test par la suite, utilisé pour des opérations de test avant la préparation du circuit électronique 10 à un collage moléculaire, le plot de test 14 reposant sur la base 12 et comprenant une face supérieure 16. Le circuit électronique 10 comprend, en outre, une couche isolante 18 recouvrant la base 12 et la périphérie du plot de test 14. La couche isolante 18 est généralement formée sur la totalité de la base 12 et du plot de test 14 et une partie de la face supérieure 16 du plot de test 14 est exposée en gravant localement une ouverture 20 dans la couche isolante 18, ce qui entraîne la formation d'une marche abrupte 22 à la périphérie de la zone exposée du plot de test 14 ayant une hauteur de 500 nm à 3 µm. En outre, l'application de pointes de test sur le plot de test 14 entraine la déformation de la face supérieure 16 du plot de test 14, ce qui a été illustré par la formation d'une aspérité 24 et d'un creux 26 représentés de façon schématique en figure 1.

La figure 2 est une image obtenue par interférométrie d'un plot de test 14 en cuivre après une opération de test. On observe notamment une aspérité 24 et un creux 26.

La figure 3 représente une courbe d'évolution du profil P de la surface du plot de test 14 de la figure 2 selon la direction D indiquée en figure 2. L'écart maximal H entre le sommet de l'aspérité 24 et le fond du creux 26 est d'environ 3 µm. De façon générale, les inventeurs ont mis en évidence que des écarts H variant de 150 nm à 5 µm peuvent être observés.

De ce fait, lors de la préparation du circuit électronique pour la réalisation d'un collage moléculaire hybride, les inventeurs ont mis en évidence que la première couche isolante du niveau d'interconnexion de collage qui est déposée et qui recouvre le plot de test 14 peut ne pas être suffisamment épaisse pour compenser les irrégularités du relief en surface du circuit électronique 10, en particulier lorsqu'une CMP est réalisée ultérieurement, de sorte que l'aspérité 26 peut être exposée.

On pourrait envisager d'augmenter l'épaisseur de l'empilement de couches isolantes du niveau d'interconnexion de collage, en particulier l'épaisseur de la première couche isolante déposée sur le plot de test 14 et dans laquelle sont formés les HBV. Toutefois, ceci peut ne pas être possible, d'une part en raison du rapport d'aspect hauteur/largeur qui en résulterait pour les ouvertures à réaliser dans cette couche isolante pour former les HBV qui peut ne pas être compatible avec les techniques utilisées pour former ces ouvertures, et d'autre part, en raison de l'augmentation des résistances électriques de ces HBV qui en résulterait et qui peut ne pas être compatible avec les propriétés électriques souhaitées pour le niveau d'interconnexion.

Les inventeurs ont mis en évidence que l'ajout d'une étape de gravure, partielle ou totale, du plot de test, permettait de pouvoir mettre en oeuvre les étapes ultérieures du procédé de préparation du circuit intégré à un collage moléculaire hybride sans les inconvénients décrits précédemment.

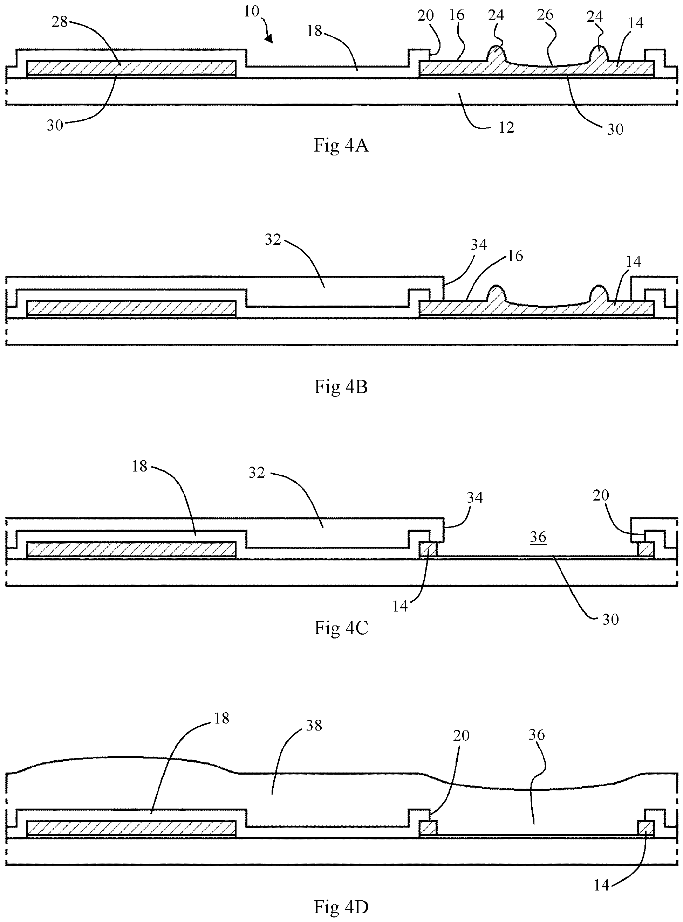

Les figures 4A à 4H sont des vues en coupe, partielles et schématiques, d'un circuit électronique à des étapes successives d'un mode de réalisation d'un procédé de préparation du circuit électronique 10 à un collage moléculaire hybride et d'un procédé de collage moléculaire hybride du circuit électronique 10.

La figure 4A représente la structure obtenue après les étapes de fabrication du circuit électronique 10, après des opérations de test du circuit électronique 10, et avant la mise en oeuvre des étapes de fabrication du niveau d'interconnexion de collage. Les étapes de fabrication du circuit électronique 10 comprennent notamment la fabrication de la base 12, des plots de test 14, un seul plot de test étant représenté en partie droite sur les figures 4A à 4H, ainsi que d'autres plots conducteurs 28, appelés plots de contact par la suite, un seul plot de contact étant représenté en partie gauche sur les figures 4A à 4H, de la couche isolante 18, et, pour chaque plot de test 14, de l'ouverture 20 dans la couche isolante 18, pour exposer une partie de la face supérieure 16 du plot de test 14. Les plots de contact 28 et les plots de test 14 peuvent être formés simultanément.

Les opérations de test ont entraîné une déformation, pour au moins certains plots de test 14, de la face supérieure 16 du plot de test 14, résultant par la formation d'aspérités 24 et d'un creux 26.

Chaque plot 14 et 28 peut avoir une structure monocouche ou une structure multicouche. Selon un mode de réalisation, la couche ou chaque couche du plot 14 ou 28 peut être en aluminium (Al), en cuivre (Cu), ou en alliage de cuivre et d'aluminium. Selon un mode de réalisation, chaque plot 14 et 28 peut être formé sur une couche 30 ou un empilement de couches jouant le rôle d'accroche pour la formation du plot 14 ou 28 et/ou de barrière pour la diffusion du matériau composant le plot 14 ou 28. A titre d'exemple, la couche 30 peut être en titane (Ti) ou en nitrure de titane (TiN). La couche 30 peut avoir une épaisseur variant de 50 nm à 150 nm, par exemple égale à environ 70 nm. Selon un mode de réalisation, l'épaisseur de chaque plot 14 et 28, en dehors des zones éventuellement déformées pour les plots de test 14, appelée épaisseur moyenne par la suite, est comprise entre 500 nm et 1,5 µm, par exemple égale à environ 975 nm. En vue de dessus, chaque plot 14 et 28 peut avoir un contour inscrit dans un carré dont le côté peut varier de 50 µm à 200 µm.

La couche isolante 18 peut avoir une structure monocouche ou une structure multicouche. Selon un mode de réalisation, la couche unique formant la couche isolante 18 ou chaque couche de la couche isolante 18 est en oxyde de silicium (SiO₂) ou en nitrure de silicium (SiN) . Selon un mode de réalisation, l'épaisseur totale de la couche isolante 18 est comprise entre 500 nm et 4 µm. Selon un mode de réalisation, pour chaque plot de test 14, le recouvrement de la face supérieure 16 du plot de test 14 par la couche isolante 18, mesuré depuis le bord latéral du plot de test 14, est compris entre 1 µm et 3 µm, par exemple égal à environ 2 µm.

La figure 4B représente la structure obtenue après la formation, sur la structure représentée en figure 4A, d'un masque de gravure 32 comprenant, pour chaque plot de test 14, une ouverture 34 exposant une partie de la face supérieure 16 du plot de test 14. Selon un mode de réalisation, le masque de gravure 32 peut être réalisé en résine photosensible et la formation de chaque ouverture 34 peut être réalisée par des étapes de photolithographie.

La figure 4C représente la structure obtenue après la gravure, au travers de l'ouverture 34, d'au moins une partie du plot de test 14 jusqu'à la couche 30, qui peut jouer le rôle de couche d'arrêt de gravure. La gravure peut correspondre à une gravure humide ou à une gravure sèche, notamment par chimie chlorée. Avantageusement dans le cas de la gravure chimique, la chimie doit attaquer le métal préférentiellement par rapport au diélectriques présents : oxide de silicium et/ou nitrure de silicium. La gravure humide peut être une gravure isotrope entraînant une gravure d'une partie du plot de test 14 sous le masque 32, comme cela est représenté en figure 4C. Toutefois, il peut être souhaitable que la gravure du plot de test 14 ne s'étende pas sous la couche isolante 18 pour ne pas fragiliser de façon excessive la structure pour la fabrication ultérieure du niveau d'interconnexion de collage. Dans ce but, pour chaque plot de test 14, les dimensions de l'ouverture 34 peuvent être inférieures à celles de l'ouverture 20. Selon un mode de réalisation, la distance entre le bord de l'ouverture 34 formée dans le masque 32 et le bord de l'ouverture 20 formée dans la couche de résine 18 peut être de l'ordre de 1 µm à 2 µm dans le cas où l'épaisseur du plot de test 14 est de l'ordre de 1 µm. Le plot de test 14 peut ne pas être gravé sur la totalité de son épaisseur. Selon un mode de réalisation, dans la zone où le plot de test 14 est gravé, le plot de test 14 est gravé sur un moins 50 % de son épaisseur moyenne, de préférence sur au moins 70 % de son épaisseur moyenne. La gravure du plot de test 14 forme une cavité 36.

La figure 4D représente la structure obtenue après le retrait du masque 32 et le dépôt d'une couche isolante 38 sur l'ensemble de la structure, la couche isolante 38 recouvrant la couche isolante 18 et remplissant la cavité 36 par l'ouverture 20. La couche isolante 38 peut avoir une structure monocouche ou une structure multicouche. Chaque couche de la couche isolante 38 peut être dans l'un des matériaux décrits précédemment pour la couche isolante 18 ou peut être en silane ou en orthosilicate de tétraéthyle (TEOS). L'épaisseur de la couche isolante 38 dépend notamment de la profondeur de la cavité 36. L'épaisseur de la couche isolante 38 est supérieure au double de l'épaisseur du plot de test 14. Selon un mode de réalisation, l'épaisseur de la couche isolante 38 peut être de l'ordre de 3 µm pour une cavité 36 ayant une profondeur de 1,5 µm.

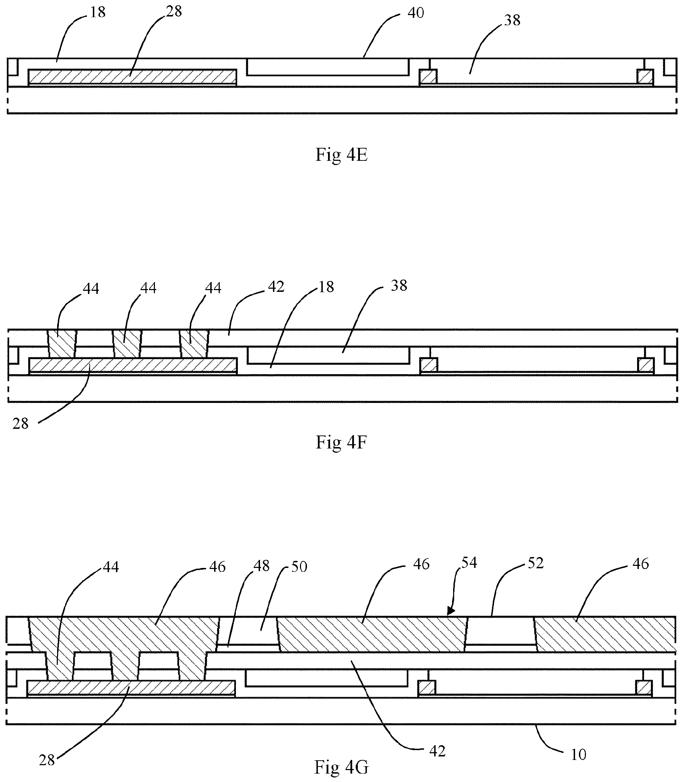

La figure 4E représente la structure obtenue après une étape de gravure partielle de la couche isolante 38 pour former une face supérieure 40 plane. La gravure peut être réalisée par CMP. Après l'étape de gravure, l'écart maximal entre les creux et les crêtes présentes sur la face supérieure 40 est inférieur à 50 nm, de préférence inférieur à 20 nm. Dans le présent mode de réalisation, l'arrêt de la gravure de la couche isolante 38 est réalisé sur la couche isolante 18. A titre de variante, l'arrêt de la gravure de la couche isolante 38 peut être réalisé avant d'atteindre la couche isolante 18, c'est-à-dire qu'une partie de la couche isolante 38 reste alors présente sur la totalité de la couche isolante 18, notamment au niveau des plots de contact 28, à la fin de l'étape de gravure. Selon une autre variante, il est prévu une couche d'arrêt de gravure avant le dépôt de la couche isolante 38. L'épaisseur de cette couche d'arrêt varie de 30 nm à 100 nm.

La figure 4F représente la structure obtenue après le dépôt éventuel d'une couche isolante 42 sur la structure représentée en figure 4E et après la formation, pour le plot de contact 28, de HBV 44 traversant la couche isolante 42, éventuellement la couche isolante 38, et la couche isolante 18, pour venir au contact du plots de contact 28. La couche isolante 42, qui peut ne pas être présente, peut être du même matériau que la couche isolante 38.

La figure 4G représente la structure obtenue après la formation des plots HBM 46, trois plots HBM 46 étant représentés à titre d'exemple en figure 4G. Ceci peut comprendre la formation d'un empilement de couches isolantes sur la structure représentée en figure 4F, un empilement de deux couches isolantes 48, 50 étant représenté à titre d'exemple en figure 4G, et la formation des plots HBM 46 dans l'empilement de couches isolantes 48, 50. La formation des plots HBM 46 peut comprendre une étape de CMP entraînant la formation d'une face de collage 52 dont l'état de surface est adapté pour la réalisation d'un collage moléculaire. Les plots HBM 46 peuvent être en cuivre. Les plots HBM 46 peuvent être connectés aux plots de contact 28 par l'intermédiaire de HBV 44 ou être isolés électriquement. L'ensemble comprenant les couches isolantes 42, 48, 50, les HBV 44 et les HBM 46 correspond au niveau d'interconnexion de collage 54 ajouté au circuit électronique 10 pour permettre la réalisation d'un collage moléculaire hybride.

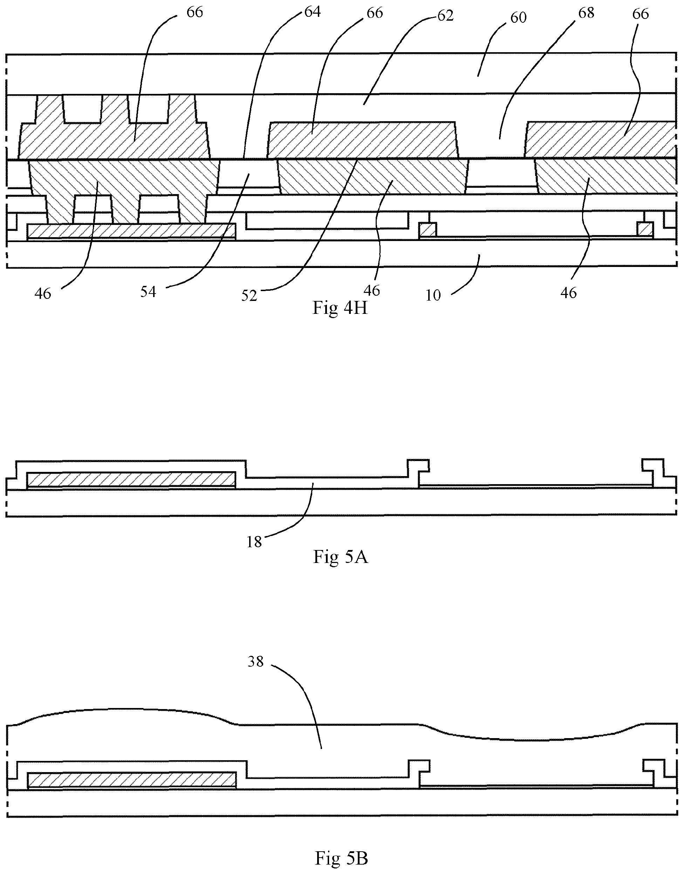

La figure 4H représente la structure obtenue après la fixation, à la face 52, par collage hybride moléculaire, d'un circuit électronique 60 auquel a été ajouté un niveau d'interconnexion de collage 62. Le niveau d'interconnexion de collage 62 comprend une face de collage 64 dont l'état de surface est adapté pour la réalisation d'un collage moléculaire. Le niveau d'interconnexion de collage 62 comprend, du côté de la face 64, des plots HBM 66 séparés par une couche isolante 68. Le collage hybride est mis en oeuvre pour que les plots HBM 46 du niveau de collage 54 ajouté au circuit électronique 10 préparé viennent en contact avec les plots HBM 66 du niveau d'interconnexion de collage 62 ajouté au circuit électronique 60.

Les figures 5A et 5B représentent les structures obtenues à des étapes successives d'un autre mode de réalisation d'un procédé de préparation du circuit électronique à un collage moléculaire hybride.

Les étapes initiales du procédé correspondent aux étapes décrites précédemment en relation avec la figure 4A.

La figure 5A représente la structure obtenue après une étape de gravure d'au moins une partie du plot de test 14, la couche isolante 18 étant utilisée comme masque de gravure pour la gravure du plot de test 14. De préférence, la totalité du plot de test 14 est gravée, comme cela est illustré en figure 5A. Le présent mode de réalisation permet de façon avantageuse d'éviter la formation d'un masque de gravure sur la couche isolante 18 pour la gravure du plot de test 14.

La figure 5B représente la structure obtenue à une étape analogue à ce qui a été décrit précédemment en relation avec la figure 4D et correspond au dépôt de la couche isolante 38 sur l'ensemble de la structure représentée en figure 5A.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que le mode de réalisation décrit précédemment en relation avec les figures 4F et 4G corresponde à un procédé de fabrication dans lequel les HBV 44 et les plots HBM 46 sont réalisés par des étapes distinctes de dépôt d'un matériau conducteur, par exemple par un procédé du type simple damascène, il est clair que les HBV 44 et les plots HBM 46 peuvent être formés en une seule étape de dépôt d'un matériau conducteur, par exemple par un procédé du type double damascène. En outre, bien que des modes de réalisation décrits précédemment concernent un dispositif électronique qui comprend l'empilement de deux circuits électroniques, il est clair que le dispositif électronique peut comprendre un empilement de plus de deux circuits électroniques, les modes de réalisation décrits précédemment pouvant s'appliquer à chaque interface entre deux circuits électroniques adjacents de l'empilement.

Enfin, la mise en oeuvre pratique des modes de réalisation et variantes décrits est à la portée de la personne du métier à partir des indications fonctionnelles données ci-dessus.

## Revendications

1. Procédé de traitement d'un circuit électronique (10) comprenant à un emplacement au moins un plot de test (14) conducteur électriquement ayant une première face (16) exposée, comprenant la gravure au moins partielle du plot de test par ladite première face, dans lequel, dans la zone où le plot de test est gravé, le plot de test est gravé sur au moins 50 % de son épaisseur moyenne, et la formation sur le circuit électronique d'un niveau d'interconnexion (54) recouvrant ledit emplacement et comprenant, du côté opposé audit emplacement, une deuxième face (52) plane adaptée pour la réalisation d'un collage moléculaire hybride.

2. Procédé selon la revendication 1, dans lequel le niveau d'interconnexion (54) comprend des plots de collage (46) conducteurs électriquement exposés sur la deuxième face (52) .

3. Procédé selon la revendication 2, dans lequel le circuit intégré (10) comprend au moins un plot de contact (28) conducteur électriquement, et dans lequel l'un des plots de collage (46) est connecté au plot de contact (28) par au moins un via (44) conducteur électriquement.

4. Procédé selon la revendication 2 ou 3, dans lequel le circuit électronique (10) comprend, avant la formation du niveau d'interconnexion (54), une première couche isolante (18) recouvrant le plot de contact, recouvrant la périphérie du plot de test (14) et traversée d'un trou (20) exposant la première face (16).

5. Procédé selon la revendication 4, dans lequel la gravure au moins partielle du plot de test (14) est réalisée au travers du trou (20) en utilisant la première couche isolante (18) comme masque de gravure.

6. Procédé selon la revendication 4 ou 5, dans lequel la périphérie du plot de test (14) recouverte par la première couche isolante (18) n'est pas gravée.

7. Procédé selon l'une quelconque des revendications 1 à 4, comprenant la formation d'un masque de gravure (32) recouvrant le circuit électronique (10) et comprenant une ouverture (34) exposant en totalité ou en partie la première face (16) et la gravure du plot de test (14) au travers de ladite ouverture.

8. Procédé selon la revendication 7, dans lequel le masque de gravure (32) est au contact de la première face (16) avant l'étape de gravure au moins partielle du plot de test (14).

9. Procédé selon l'une quelconque des revendications 1 à 8, dans lequel l'étape de formation du niveau d'interconnexion (54) comprend une étape de planarisation mécano-chimique.

10. Procédé selon l'une quelconque des revendications 1 à 9, comprenant, avant l'étape de gravure au moins partielle du plot de test (14), une étape de test du circuit électronique (10) comprenant l'application d'au moins une pointe conductrice électriquement contre le plot de test (14) .

11. Procédé selon l'une quelconque des revendications 1 à 10, comprenant le collage moléculaire hybride de la deuxième face (52) à une troisième face (64) d'un autre circuit électronique (62).

12. Procédé selon l'une quelconque des revendications 1 à 11, dans lequel, dans la zone où le plot de test (14) est gravé, le plot de test (14) est gravé sur toute son épaisseur.

13. Procédé selon l'une quelconque des revendications 1 à 12, dans lequel le plot de test (14) est formé sur une deuxième couche (30), la gravure au moins partielle du plot de test (14) étant réalisée jusqu'à atteindre la deuxième couche (30), la deuxième couche (30) servant de couche d'arrêt à la gravure.

14. Procédé selon l'une quelconque des revendications 1 à 13, dans lequel le plot de test (14) est gravé en totalité.
